# EUROPEAN PATENT SPECIFICATION

(11) **EP 0 366 360 B1**
(45) Date of publication and mention of the grant of the patent: **15.12.1993**
(21) Application number: 89310767.2
(22) Date of filing: 19.10.1989
(51) Int. Cl.: G01R 35/00, G01R 15/06

(54) **Proving apparatus & method for high voltage detectors**
Gerät und Verfahren für die Prüfung von Hochspannungsdetektoren
Appareil et méthode pour éprouver des détecteurs de haute tension

(30) Priority: 24.10.1988 GB 8824844; 23.01.1989 GB 8901415
(43) Date of publication of application: 02.05.1990
(73) Proprietor: EDGCUMBE INSTRUMENTS LIMITED, Crawley, West Sussex RH10 2RZ (GB)
(72) Inventor: Binnie, Alexander J., Dunblane Perthshire Scotland (GB); Wyne, William A., Strathaven Lanarkshire Scotland (GB)
(74) Representative: Gibson, Stewart Harry

(56) References cited:
- DE-A- 3 712 783
- US-A- 3 701 944

## Description

This invention relates to apparatus for and a method of proving capacitive-type high voltage detectors.

The principle of operation of capacitive-type high voltage detectors utilises the capacitance to earth of a screen associated with electronic evaluation circuitry in the detector. The screen is connected to a contact probe and when the screen is at the voltage potential of a high voltage conductor against which the probe has been touched, a capacitive current flows which is proportional to the voltage potential. This current is detected by the electronic circuitry which then measures from it the voltage on the conductor and can actuate visual and audible indicators associated with the circuitry. Another capacitive-type high voltage detector is known from US-A-3 701 944.

Capacitive-type detectors are used by maintenance personnel in the electrical supply industry to check that high voltage circuits are de-energised before they work on these circuits. The detectors are therefore safety instruments and, due to the lethal nature of high voltage circuits, it is of prime importance to be able to test or prove the integrity of these instruments before they are used.

Most commercial capacitive-type high voltage detectors have a facility built into them to prove the integrity of their operation. This facility, however, provides only a test, normally a go/no-go test, which does not confirm that the instrument switches at the correct threshold voltage and never checks the complete circuit. Of course, a more comprehensive check can be made using an external source, but that would require a source able, for example, to provide a voltage of 1.65kV to 4.4kV for an 11kV high voltage detector, or 19.8kV to 52.8kV for a 132kV detector. To provide external test sources that could produce such high voltages would incur problems that would make their application totally impractical.

It is an object of the present invention to provide a method of, and apparatus for, proving the operation of capacitive-type high voltage detectors which will not require the use of an excessively high voltage source.

According to one aspect of the invention, there is provided a proving apparatus in combination with a capacitive-type high voltage detector to be proved, the detector comprising a body carrying a contact probe connected by a capacitor to a screen member in the body, said screen member being arranged to produce, in use of the detector, a capacitive effect in relation to earth, and the proving apparatus comprising a receiver in or against which the detector is placed, said receiver having a conductive element forming a capacitance with said screen member in the detector, the proving apparatus further comprising a contact element engaged with the contact probe of the detector and means for applying a varying voltage across said conductive element and said contact element, the conductive element being arranged to form a substantially greater capacitive effect with the screen member of the detector than said screen member forms with earth in operative use of the detector.

The receiver may be in the form of a hollow container forming a receptacle for the detector and preferably conforming generally to the external shape of the detector. For example, for detectors formed by a rounded body with a frusto-conical leading end the container can be given an inner substantially frusto-conical internal surface and preferably a substantially cylindrical internal surface continuing from the larger end of said frusto-conical surface. The element is preferably disposed on or close to the internal surface or surfaces of the hollow container and extends over a major part of the area thereof.

According to another aspect of the invention, there is provided a method of proving a capacitive-type high voltage detector, the detector comprising a body carrying a contact probe connected by a capacitor to a screen member in the body, said screen member being arranged to produce in use of the detector, a capacitive effect in relation to earth, the method comprising the steps of engaging the detector body with a conductive element to form a capacitance with said screen member in the detector, which capacitance is substantially greater than the capacitance between the screen member and earth in operative use of the detector, engaging a contact element with the contact probe of the detector, and applying a varying voltage across said conductive element and said contact element so as to actuate the detector.

The varying voltage for the proving method can be produced as an AC voltage. Alternatively it is possible to employ a chopped DC signal.

The invention will now be further described by way of example with reference to the accompanying schematic drawings, in which:
Figure 1 shows a typical capacitive-type high voltage detector, and
Figures 2 to 4 are block diagrams of alternative forms of proving apparatus according to the invention for the detector of Figure 1.

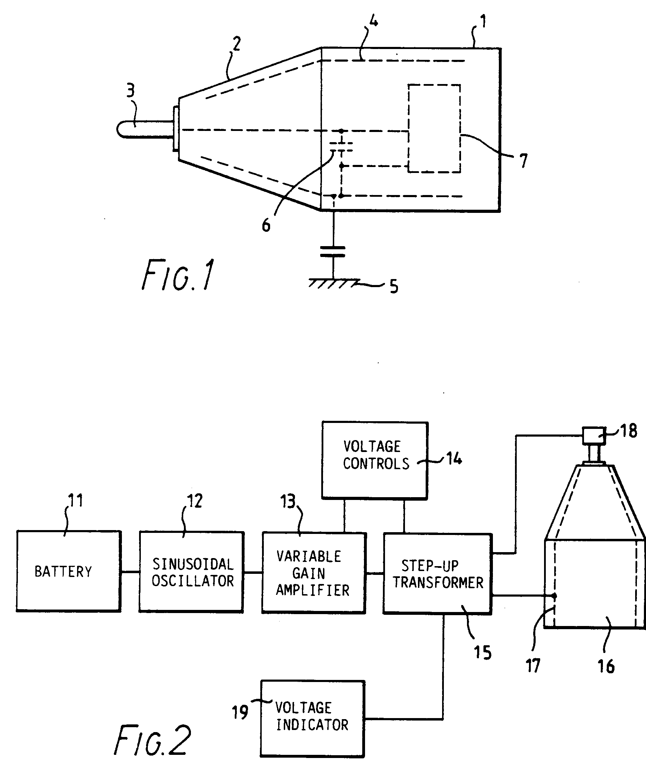

Referring to Figure 1, a typical capacitive-type high voltage detector such as is shown there normally has a body 1 with a frusto-conical nose 2, made from a plastics material with good insulating properties. At the tip of the nose there is a metal probe 3 which is touched against the high voltage conductor to be tested. Inside the body of the cone there is a metallic screen 4 connected to the probe 3 via an internal capacitor 6. The screen 4 provides a capacitive path to earth 5 with a capacitance value that can be taken as being relatively constant in use. When the probe 3 is touched onto a conductor (not shown) at high voltage, a capacitive current will flow through the internal capacitor and through the capacitance from the screen 4 to earth 5.

Because the capacitance of the screen to earth has a very low value, generally about 3 to 5 pico-farads, and the internal capacitor 6 is chosen to be normally very large in comparison with the capacitance of the screen to earth, the current through the capacitance 6 is therefore proportional to the voltage on the conductor and the capacitance from the screen to earth. The voltage across the capacitor 6 is fed into an electronic evaluating section 7 of the detector where it is able to actuate visual and/or audible indicators (not shown). The value of the capacitor 6 is generally chosen so that there is a voltage of 1 volt across it at the threshold, or switching, voltage of the electronic section 7.

Fig. 2 illustrates a proving apparatus for the high voltage detector of Fig. 1. The apparatus includes a circuit which comprises a power source 11, for example, a 9 volt battery, which operates a sinusoidal oscillator 12 which produces a stable sinusoidal waveform having, for example, an amplitude of 1 volt RMS. The oscillator can have fixed or adjustable frequency, for example at some 50 to 60Hz. The oscillator 12 outputs to a variable gain amplifier 13 which allows the waveform to be amplified by means of a voltage control 14 mounted on a front panel (not shown) of the apparatus. The output of the amplifier 13 is a differential power stage providing an output voltage which is variable from 0 to about 7 volts RMS. The differential output is connected across the primary of step-up transformer 15, and the secondary of the transformer provides a step-up ratio, for example between about 50 to 200, which can be selected by the voltage control. The voltage on the transformer secondary circuit can therefore be varied from 0 up to between 350 and 1400 volts RMS.

The transformer secondary is connected to a proving fixture 16 in the apparatus. The fixture 16 is formed as a hollow body designed to receive the detector under test fitting closely within it and the inner surfaces of the body are preferably substantially conformal with the adjoining surfaces of the detector. One secondary terminal is connected to an internal metal screen 17 in the fixture body or close to its inner surface, and the other terminal is connected to a conductor 18 projecting concentrically into the tapered inner end of the body. When the detector is inserted into the fixture, its probe 3 contacts the conductor 18 and its screen 4 lies close to the screen 17.

In this position, it can be arranged that the capacitance between the screens 4 and 17 is much larger than the capacitance to earth of the internal screen 4 of the detector. Accordingly, the detector will be triggered at much lower voltages than its normal threshold voltage. It is therefore possible to check the threshold voltage of the detector using a voltage value which is only a fraction of the appropriate voltage for the screen-earth capacitance effect.

It has been noted that the capacitance to earth of the metallic screen 4 within the detector is relatively constant, and that the capacitance between the screen 4 and the screen 17 of the fixture is also relatively constant. Thus, if the voltage supplied by the step-up transformer 15 is monitored, eg. on a voltage indicator 19, by scaling the reading it is possible to determine the equivalent voltage for the detector when it is in normal use. This allows the threshold voltage of the detector to be accurately determined using a voltage very considerably less than the normal operational voltage, by increasing the transformer step-up ratio until the detector is triggered.

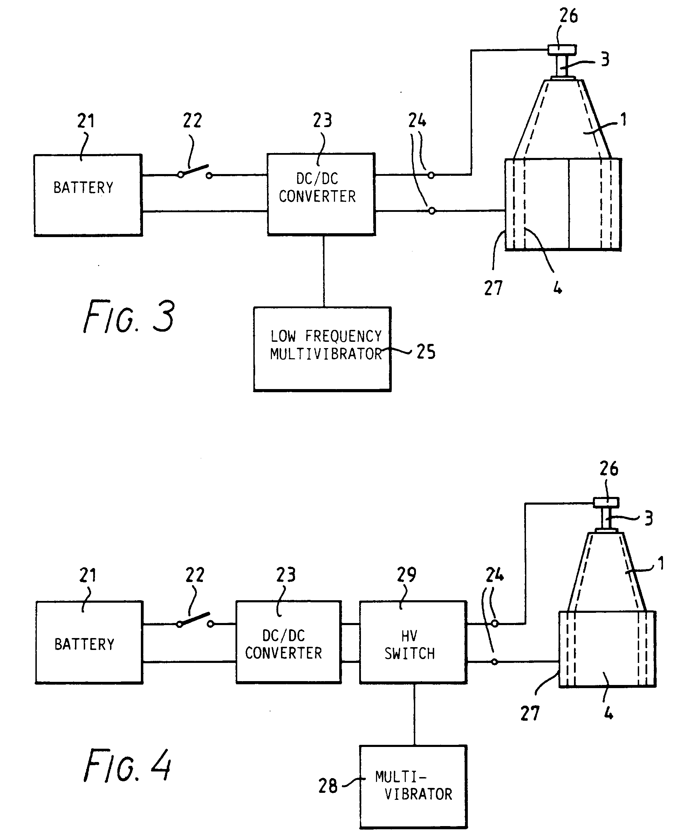

Fig. 3 illustrates an alternative proving apparatus for the high voltage detector of Fig. 1. The apparatus includes electronic circuit powered by a power source 21, for example, a 9 volt battery, which is connected to the electronic circuit by an on-off switch 22. When the switch 22 is closed a DC/DC converter 23 of the circuit produces a high DC voltage, typically 1000 volts, across the output terminals 24 of the proving apparatus. Means may be provided to vary the output voltage, as in the first example described. The circuit also incorporates a low frequency multivibrator 25 with a frequency of typically 10HZ which switches the DC/DC converter on and off. Therefore, the signal across the output terminals 24 of the proving apparatus is a square wave with a frequency of 10HZ and a peak to peak voltage of 1000 volts.

One terminal of the proving apparatus is connected via a lead with a crocodile-type clip 26 to the probe 3 of the high voltage detector to be proved. The other terminal of the proving apparatus is connected via a lead to a flexible, conductive strip 27 which is wrapped round the body 1 of the high voltage detector. This flexible strip could be made of robust, conductive foam, and it may be held in position by either stud fasteners or so-called touch-and-close fastening strips (not shown).

The conductive strip 27 is so configured that the capacitance between the internal screen 4 of the detector and the strip is much larger than the capacitance to earth of the screen 4. Accordingly, the detector will be triggered at much lower voltages than its normal threshold voltage. It is, therefore, possible to check this operation of the detector using a voltage value which is only a fraction of the appropriate voltage for the screen-earth capacitance effect.

This illustrated apparatus and its method of operation are not intended to determine the threshold voltage of a detector. Its purpose rather is to provide in a simple and economical way a go/no-go tester which checks that the high voltage detector is operating correctly, without measuring its switching threshold voltage.

Fig. 4 illustrates a further alternative proving apparatus for the high voltage detector. In certain instances, the low frequency test signal available from the apparatus in Fig. 3 has too low a frequency to activate certain high voltage detectors. The apparatus illustrated in Fig. 4 can circumvent such problems. It takes a similar form to the apparatus of Fig. 3 and components already described in the previous example are indicated by the same reference numbers. It differs in that it employs a multivibrator 28 having a frequency, typically 50Hz, higher than that of the multivibrator 25, which switches a high voltage switch 29 so that the signal across the output terminals 24 of the proving apparatus is a square wave at the multivibrator frequency and with a peak to peak voltage of typically 10000 volts. The high voltage switch 29 would conveniently be a high-voltage power MOS-FET.

Many modifications may be made within the scope of the present invention. For example, in place of the performed hollow body 16 of the illustrated examples, a receiver for the detector can be provided by a flexible sleeve that can be wrapped around the detector body, the sleeve consisting of or containing conductive material so as to be able to provide a suitably high capacitive effect with the detector screen member.

## Claims

1. A proving apparatus in combination with a capacitive-type high voltage detector to be proved, the detector comprising a body (1) carrying a contact probe (3) connected by a capacitor (6) to a screen member (4) in the body (1), said screen member (4) being arranged to produce, in use of the detector, a capacitive effect in relation to earth (5), and the proving apparatus comprising a receiver (16) in or against which the detector is placed, said receiver (16) having a conductive element (17 or 27) forming a capacitance with said screen member (4) in the detector, the proving apparatus further comprising a contact element (18 or 26) engaged with the contact probe (3) of the detector and means (11 to 15) for applying a varying voltage across said conductive element (17 or 27) and said contact element (18 or 26), the conductive element (17 or 27) being arranged to form a substantially greater capacitive effect with the screen member (4) of the detector than said screen member (4) forms with earth (5) in operative use of the detector.

2. Apparatus according to claim 1 **characterised by** means (14) for adjusting the voltage applied across said conductive element (17) and contact element (18).

3. Apparatus according to claim 2 **characterised in that** said means for adjusting the applied voltage comprises voltage control means (14) for a variable gain amplifier (13) and/or a step-up transformer (15) in said voltage applying means.

4. Apparatus according to claim 2 or 3 **characterised by** means (19) for measuring the voltage across said elements and for providing a scaled-up reading of the measurement.

5. Apparatus according to claim 1 or claim 2 **characterised by** a DC-DC converter (23) arranged to produce a stepped-up voltage and chopping means (28, 29) to interrupt the output of said converter cyclically to give said varying voltage across said conductive element (27) and contact element (26).

6. Apparatus according to claim 5 **characterised in that** said chopping means comprises a switch (29) on the output side of the DC-DC converter (23) and multivibrator means (28) controlling said switch (29).

7. Apparatus according to any of the preceding claims **characterised in that** said receiver (16) comprises a hollow container forming a receptacle for the detector.

8. Apparatus according to any one of claims 1 to 6 **characterised in that** the receiver (16) is formed by a flexible sleeve consisting of or containing conductive material forming said conductive element (27).

9. A method of proving a capacitive-type high voltage detector, the detector comprising a body (1) carrying a contact probe (3) connected by a capacitor (6) to a screen member (4) in the body (1), said screen member (4) being arranged to produce a capacitive effect in relation to earth (5), the method comprising the steps of engaging the detector body (1) with a conductive element (17 or 27) to form a capacitance with said screen member (4) in the detector, which capacitance is substantially greater than the capacitance between the screen member (4) and earth (5) in operative use of the detector, engaging a contact element (18 or 26) with the contact probe (3) of the detector, and applying a varying voltage across said conductive element (17 or 27) and said contact element (18 or 26) so as to actuate the detector.

10. A method according to claim 9, **characterised by** the step of forming a measurement of the applied voltage and scaling up the measurement to indicate the actuating voltage of the detector in its normal use.

## Patentansprüche

1. Prüfgerät in Verbindung mit einem zu prüfenden Hochspannungsdetektor kapazitiven Typs, wobei der Detektor einen Körper (1) mit einem Kontaktmeßkopf (3) aufweist, der durch einen Kondensator (6) mit einem Abschirmungselement (4) in dem Körper (1) verbunden ist, wobei das Abschirmungselement (4) so angeordnet ist, daß es bei Verwendung des Detektors eine kapazitive Wirkung bezüglich Erde (5) hervorruft, und wobei das Prüfgerät eine Aufnahmevorrichtung (16) aufweist, in die oder gegen die der Detektor placiert wird, wobei die Aufnahmevorrichtung (16) ein leitendes Element (17 oder 27) besitzt, das mit dem Abschirmungselement (4) in dem Detektor eine Kapazität bildet, wobei das Prüfgerät weiterhin ein Kontaktelement (18 oder 26), das mit dem Kontaktmeßkopf (3) des Detektors in Eingriff steht, und Mittel (11 bis 15) zum Anlegen einer variierenden Spannung über das leitende Element (17 oder 27) und das Kontaktelement (18 oder 26) aufweist, wobei das leitende Element (17 oder 27) so angeordnet ist, daß es bei der betriebsmäßigen Anwendung des Detektors eine wesentlich größere kapazitive Wirkung mit dem Abschirmungselement (4) des Detektors hervorruft als das Abschirmungselement (4) gegen Erde (5).

2. Gerät gemäß Anspruch 1, gekennzeichnet durch Mittel (14) zum Einstellen der über das leitende Element (17) und das Kontaktelement (18) angelegten Spannung.

3. Gerät gemäß Anspruch 2, dadurch gekennzeichnet, daß das Mittel zum Einstellen der angelegten Spannung Spannungssteuerungsmittel (14) für einen Verstärker (13) mit veränderlicher Verstärkung und/oder einen Aufwärtstransformator (15) in dem Mittel zum Anlegen der Spannung aufweist.

4. Gerät gemäß Anspruch 2 oder 3, gekennzeichnet durch Mittel (19) zum Messen der Spannung über den Elementen und zum Schaffen einer maßstäblich vergrößerten Anzeige des Meßergebnisses.

5. Gerät gemäß Anspruch 1 oder Anspruch 2, gekennzeichnet durch einen Gleichspannung-Gleichspannung-Wandler (23), der so angeordnet ist, daß er eine aufwärtstransformierte Spannung erzeugt, und durch Zerhackermittel (28, 29) zum zyklischen Unterbrechen des Ausgangssignals des Wandlers, um die variierende Spannung über das leitende Element (27) und das Anschlußelement (26) zu erzeugen.

6. Gerät gemäß Anspruch 5, dadurch gekennzeichnet, daß das Zerhackermittel einen Schalter (29) auf der Ausgangsseite des Gleichspannungs-Gleichspannungs-Wandlers (23) und den Schalter (29) steuernde Multivibratormittel (28) aufweist.

7. Gerät gemäß einem der vorangehenden Ansprüche, dadurch gekennzeichnet, daß die Aufnahmevorrichtung (16) einen hohlen Behälter, der ein Aufnahmebehältnis für den Detektor bildet, umfaßt.

8. Gerät gemäß einem der Ansprüche 1 bis 6, dadurch gekennzeichnet, daß die Aufnahmevorrichtung (16) durch eine flexible Hülse gebildet ist, die aus einem leitenden, das genannte leitende Element (27) bildenden Material besteht oder es enthält.

9. Verfahren für die Prüfung eines Hochspannungsdetektors kapazitiven Typs, wobei der Detektor einen Körper (1) mit einem Kontaktmeßkopf (3) aufweist, der durch einen Kondensator (6) mit einem Abschirmungselement (4) in dem Körper (1) verbunden ist, wobei das Abschirmungselement (4) so angeordnet ist, daß es eine kapazitive Wirkung bezüglich Erde (5) hervorruft, wobei das Verfahren die Schritte aufweist, den Detektorkörper (1) und ein leitendes Element (17 oder 27) in Eingriff zu bringen, um eine Kapazität mit dem Abschirmungselement (4) in dem Detektor zu bilden, wobei diese Kapazität bei der betriebsmäßigen Anwendung des Detektors wesentlich größer ist als die Kapazität zwischen dem Abschirmungselement (4) und Erde (5), ein Anschlußelement (18 oder 26) und den Kontaktmeßkopf (3) des Detektors in Eingriff zu bringen und eine variierende Spannung über das leitende Element (17 oder 27) und das Kontaktelement (18 oder 26) anzulegen, um den Detektor zu betätigen.

10. Verfahren gemäß Anspruch 9, gekennzeichnet durch den Schritt der Durchführung einer Messung der angelegten Spannung und des maßstäblichen Vergrößerns des Meßergebnisses, um die Betätigungsspannung des Detektors bei seiner normalen Anwendung anzuzeigen.

## Revendications

1. Un appareil pour éprouver un détecteur de haute tension de type capacitif, le détecteur comprenant un corps (1) portant un capteur de contact (3) connecté par une capacité (6) à un élément écran (4) placé dans le corps (1), ledit élément écran (4) étant prévu pour produire, lorsque le détecteur est en fonctionnement, un effet capacitif avec la terre (5), et l'appareil comprenant un récepteur (16) dans ou contre lequel ledit détecteur est placé, ledit récepteur (16) ayant un élément conducteur (17 ou 27) formant une capacité avec ledit élément écran (4) dans le détecteur, l'appareil comprenant de plus un élément de contact (18 ou 26) engagé dans le capteur de contact (3) du détecteur et des moyens (11 à 15) d'application d'une tension variable entre ledit élément conducteur (17 ou 27) et ledit élément de contact (18 ou 26), l'élément conducteur (17 ou 27) étant prévu pour produire un effet capacitif avec l'élément écran (4) du détecteur sensiblement plus grand que celui produit par ledit élément écran (4) avec la terre (5) lorsque le détecteur est en fonctionnement.

2. Appareil selon la revendication 1 caractérisé par des moyens (14) d'ajustement de la tension appliquée entre ledit élément conducteur (17) et ledit élément de contact (18).

3. Appareil selon la revendication 2 caractérisé en ce que lesdits moyens d'ajustement de la tension appliquée comprend des moyens (14) de contrôle de la tension contrôlant un amplificateur à gain variable (13) et/ou un transformateur élévateur (15) dans lesdits moyens d'application d'une tension variable.

4. Appareil selon la revendication 2 ou 3, caractérisé par des moyens (19) de mesure de la tension entre lesdits éléments et de production d'un relevé agrandi à l'échelle de la mesure.

5. Appareil selon la revendication 1 ou 2 caractérisé par un convertisseur continu-continu (23) prévu pour produire une tension augmentée et des moyens (28, 29) de hachage pour interrompre cycliquement la sortie dudit convertisseur pour délivrer ladite tension variable entre ledit élément conducteur (27) et ledit élément de contact (26).

6. Appareil selon la revendication 5 caractérisé en ce que lesdits moyens de hachage comprennent un commutateur (29) sur la sortie du convertisseur continu-continu (23) et un multivibrateur (28) contrôlant ledit commutateur (29).

7. Appareil selon l'une quelconque des revendications précédentes, caractérisé en ce que ledit récepteur (16) comprend un conteneur évidé formant un réceptacle pour ledit détecteur.

8. Appareil selon l'une quelconque des revendication 1 à 6, caractérisé en ce que ledit récepteur (16) est formé par un manchon flexible réalisé en ou contenant un matériau conducteur formant ledit élément conducteur (27).

9. Une méthode pour éprouver un détecteur de haute tension de type capacitif, le détecteur comprenant un corps (1) portant un capteur de contact (3) connecté par une capacité (6) à un élément écran (4) placé dans le corps (1), ledit élément écran (4) étant prévu pour produire un effet capacitif avec la terre (5); la méthode comprenant les étapes d'engagement dans le corps (1) du détecteur d'un élément conducteur (17 ou 27) pour former une capacité entre ledit élément écran (4) dans le détecteur, ladite capacité étant sensiblement supérieure à la capacité entre l'élément écran (4) et la terre (5) lorsque le détecteur est en fonctionnement, d'engagement d'un élément de contact (18 ou 26) dans le capteur de contact (3) du détecteur, et d'application d'une tension variable entre ledit élément conducteur (17 ou 27) et ledit élément de contact (18 ou 26) de façon à actionner le détecteur.

10. Une méthode selon la revendication 9, caractérisée par l'étape de mesure de la tension appliquée et d'augmentation de l'échelle de la mesure pour indiquer la tension d'actionnement du détecteur en fonctionnement normal.
